# EUROPEAN PATENT SPECIFICATION

(11) **EP 3 547 439 B1**
(45) Date of publication and mention of the grant of the patent: **21.06.2023**
(21) Application number: 18164875.9
(22) Date of filing: 29.03.2018
(51) Int. Cl.: H01P 1/20, H01P 1/203, H01P 1/213, H03H 7/01, H03H 7/09, H03H 7/46

(54) **A BAND PASS FILTER, A DIPLEXER AND METHOD FOR FORMING A BAND PASS FILTER**
BANDPASSFILTER, DIPLEXER UND VERFAHREN ZUR HERSTELLUNG EINES BANDPASSFILTERS
FILTRE PASSE-BANDE, DIPLEXEUR ET PROCÉDÉ DE FORMATION D'UN FILTRE PASSE-BANDE

(43) Date of publication of application: 02.10.2019
(73) Proprietor: Intel Corporation, Santa Clara, CA 95054 (US)
(72) Inventor: BLAY, Genadi, Bat Yam 5944733 (IL); GROSS, Shay, 30875 Megadim (IL); ZOHAR, Uzi, 3900000 Ramat Gan HA (IL)
(74) Representative: 2SPL Patentanwälte PartG mbB

(56) References cited:
- EP-A1- 1 317 014
- WO-A1-2017/160282
- JP-A- 2004 266 696
- JP-A- 2004 266 697
- US-A1- 2006 279 380

## Description

### Field

Examples relate to radio frequency RF front end concepts and in particular to a band pass filter, a diplexer and method for forming a band pass filter.

### Background

Nowadays RF front end circuits include many components such as transmitters, receivers, transceivers, matching networks, diplexers, duplexers and filters. It may be desired to reduce the costs and/or the space consumption and/or improve the performance of RF front end circuits.

US 2006/279380 discloses a second-order bandpass filter. US 2006/279380 discloses that a grounding capacitor is connected electrically to a two-port network as a feedback path to provide two finite transmission zeros. US 2006/279380 shows a conventional bandpass filter in Fig. 1. US 2006/279380 discloses that in this second-order bandpass filter, a coupling capacitor C provides a feedback path and thus generates the two finite zeros. US 2006/279380 discloses that the second-order bandpass filter according to the present invention comprises a two-port network and a grounding capacitor.

WO 2017/160282 discloses an apparatus including a first transmission path for a first frequency band, a second transmission path for a second frequency band different from the first frequency band, a node common to the first and second transmission paths, the node to be coupled to an antenna, and a transmission-zero circuit coupled to the common node.

JP 2004 266697 discloses a multilayer bandpass filter. JP 2004 266697 discloses a laminated band-pass filter capable of changing coupling between resonators without changing the shape of electrodes of the resonators, and capable of easily changing a pass band and an attenuation pole frequency of the BPF.

EP 1317014 discloses a filter circuit including a plurality of resonators wherein an impedance between respective input/output terminals and a reference potential line is maximum in each resonance frequency and each input/output terminal is capacitive-coupled to at least one of other input/output terminals, first capacitive coupling means for capacitive-coupling input/output terminals of any two resonators of the plurality of resonators and first and second terminals respectively to each other, and electromagnetic field coupling means for connecting the first and second terminals respectively to the input terminal and the output terminal and bringing the input terminal and the output terminal into magnetic field coupling by mutual induction.

### Brief description of the Figures

Some examples of apparatuses and/or methods will be described in the following by way of example only, and with reference to the accompanying figures, in which
Fig. 1 shows a schematic layout of a band pass filter;
Fig. 2a shows an equivalent circuit of a 2.4 GHz band pass filter with symmetric topology;
Fig. 2b shows an equivalent circuit of a 2.4 GHz band pass filter with substantially symmetric topology;
Fig. 3 shows a schematic layout of a 2.4GHz band pass filter implementation using SMT caps instead of plate capacitors;
Fig. 4 shows an equivalent circuit of a 2.4 GHz band pass filter with asymmetric topology;
Fig. 5 shows a schematic layout of a 2.4GHz band pass filter implementation using relocated SMT caps relative to the ports and lumped inductance;
Fig. 6 shows an equivalent circuit of a diplexer;
Fig. 7 shows a schematic layout implementation of a fully functional WiFi/BT diplexer;
Fig. 8 shows a schematic illustration of a 2.4GHz band-pass filter response with SMT capacitor located in the location shown in Fig. 3 vs. the locations shown in Fig. 5;
Fig. 9 shows a schematic illustration of a simulated performance of a diplexer as seen from the 2.4GHz and the 5GHz ports towards the antenna port;
Fig. 10 shows a schematic illustration of a simulated in-band performance of a diplexer as seen from the 2.4GHz ports towards the antenna port;
Fig. 11 shows a schematic illustration of a simulated in-band performance of diplexer as seen from the 5GHz ports towards the antenna port;
Fig. 12 shows a flow chart of a method for forming a band pass filter;
Fig. 13 illustrates a user device; and
Fig. 14 illustrates a base station or infrastructure equipment radio head.

### Detailed Description

Various examples will now be described more fully with reference to the accompanying drawings in which some examples are illustrated. In the figures, the thicknesses of lines, layers and/or regions may be exaggerated for clarity.

It will be understood that when an element is referred to as being "connected" or "coupled" to another element, the elements may be directly connected or coupled or via one or more intervening elements. If two elements A and B are combined using an "or", this is to be understood to disclose all possible combinations, i.e. only A, only B as well as A and B, if not explicitly or implicitly defined otherwise. An alternative wording for the same combinations is "at least one of A and B" or "A and/or B". The same applies, mutatis mutandis, for combinations of more than two Elements.

The terminology used herein for the purpose of describing particular examples is not intended to be limiting for further examples. Whenever a singular form such as "a," "an" and "the" is used and using only a single element is neither explicitly or implicitly defined as being mandatory, further examples may also use plural elements to implement the same functionality. Likewise, when a functionality is subsequently described as being implemented using multiple elements, further examples may implement the same functionality using a single element or processing entity. It will be further understood that the terms "comprises," "comprising," "includes" and/or "including," when used, specify the presence of the stated features, integers, steps, operations, processes, acts, elements and/or components, but do not preclude the presence or addition of one or more other features, integers, steps, operations, processes, acts, elements, components and/or any group thereof.

Unless otherwise defined, all terms (including technical and scientific terms) are used herein in their ordinary meaning of the art to which the examples belong.

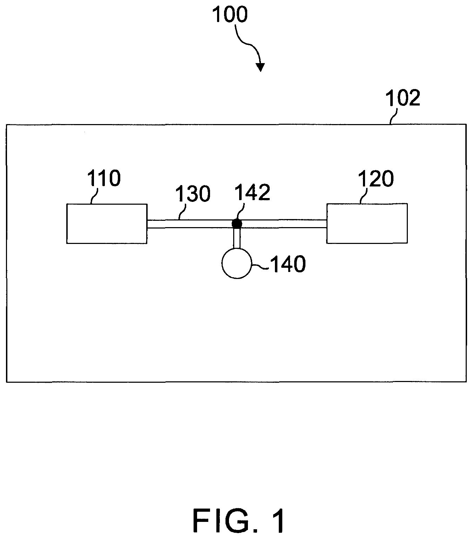

Fig. 1 shows a schematic layout of a band pass filter according to an example. The band pass filter 100 comprises a first discrete capacitor 110 coupled (e.g. disposed on, attached to and/or connected to) to a circuit board 102 and a second discrete capacitor 120 coupled (e.g. disposed on, attached to and/or connected to) to the circuit board 102. Further, the band pass filter 100 comprises a conductive board trace 130 extending from a first terminal of the first discrete capacitor 110 to a first terminal of the second discrete capacitor 120. Additionally, a reference potential terminal 140 is coupled to the conductive board trace 130 at a reference potential node 142 located on the conductive board trace. For example, the reference potential node 142 may be coupled to the conductive board trace 130 at a reference potential node 142 disposed between the first discrete capacitor 110 and the second discrete capacitor 120.

By using discrete capacitors for the band pass filter, the actually obtained capacitance may match a desired capacitance very accurately, since the tolerance of discrete capacitors is very low. Therefore, in comparison to capacitors implemented by metal layers of a circuit board with large tolerances, the capacitance variations and consequently performance variations of band pass filters may be kept low. Further, discrete capacitors may be very compact components so that the space consumption of the band pass filter may be low.

The first and second discrete capacitor may be discrete and electrically passive components attached (e.g. soldered) to the circuit board 102. Each discrete capacitor such as the first discrete capacitor 110 and the second discrete capacitor 120 may comprise two terminals electrically connected (e.g. soldered) to the circuit board 102. Each of the first and second discrete capacitors 110 and 120 comprises a first terminal electrically coupled to the conductive board trace 130. Further, of the first and second discrete capacitors 110 and 120 may comprise a second terminal electrically coupled to a reference potential contact (e.g. ground contact), which is electrically connected to the reference potential terminal 140 (e.g. via a reference potential layer or plane of the circuit board) of the circuit board 102. For example, discrete capacitors such as the first discrete capacitor and/or the second discrete capacitor may be surface-mount technology SMT capacitors, capacitors embedded in the circuit board (e.g. PCB), and coupled by traces, vias and/or wires to other components (e.g. integrated circuits and/or discrete components) and/or capacitors implemented with a printed metal. For the following examples surface-mount technology SMT capacitors are used, although other discrete capacitors may be used alternatively or additionally.

The conductive board trace 130 may be an electrically conductive line of electrically conductive material (e.g. copper or copper alloy) implemented in a wiring layer of the circuit board 102. The conductive board trace 130 extends at least from the first terminal of the first surface-mount technology capacitor 110 to the first terminal of the second surface-mount technology capacitor 120, for example.

The reference potential terminal 140 may be a contact interface (e.g. connector interface or solder interface) of the circuit board 102 for connecting the circuit board 102 to a reference potential or a reference potential contact interface of band pass filter 100. The reference potential (e.g. ground potential) may be a potential supplied by a DC power supply or a battery coupled to the reference potential terminal 140 or by a connection to a chassis of the device. The reference potential terminal 140 may be electrically coupled to the reference potential node at the conductive board trace 130 via a reference potential layer or plane of the circuit board.

For example, the reference potential node 142 is a position along the conductive board trace 130 where the conductive board trace 130 is coupled to the reference potential terminal 140. The reference potential node may be pulled to the reference potential during operation of the band pass filter 100 due to a low-ohmic connection between the reference potential node 142 and the reference potential terminal 140. For example, the reference potential node is located somewhere along the conductive board trace 130 between the first terminal of the first surface-mount technology capacitor 110 and the first terminal of the second surface-mount technology capacitor 120. For example, the reference potential node 142 may be located close to the mid-point between the first terminal of the first surface-mount technology capacitor 110 and the first terminal of the second surface-mount technology capacitor 120. In some examples, a first distance between the reference potential node 142 and the first terminal of the first surface-mount technology capacitor 110 along the conductive board trace 130 may differ from a second distance between the reference potential node 142 and the first terminal of the second surface-mount technology capacitor 120 along the conductive board trace 130 by less than 20% (or less than 10% or less than 5%) of the first distance.

For example, the band pass filter 100 comprises a first terminal of the band pass filter 100 coupled to the conductive board trace 130 at a first node. The first node may be disposed closer to the first terminal of the first surface-mount technology capacitor 110 than the reference voltage node 140. The first terminal of the band pass filter 100 may be a first port of the band pass filter 100 for connecting the band pass filter 100 to an antenna or a receiver or transmitter.

For example, the band pass filter 100 comprises a second terminal of the band pass filter 100 coupled to the conductive board trace at a second node. The second node may be disposed closer to the first terminal of the second surface-mount technology capacitor 120 than the reference voltage node 140. The second terminal of the band pass filter 100 may be a second port of the band pass filter 100 for connecting the band pass filter 100 to an antenna or a receiver or transmitter.

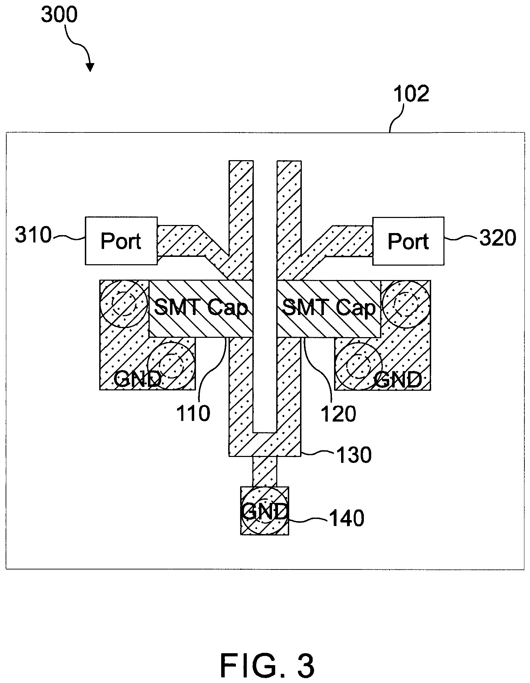

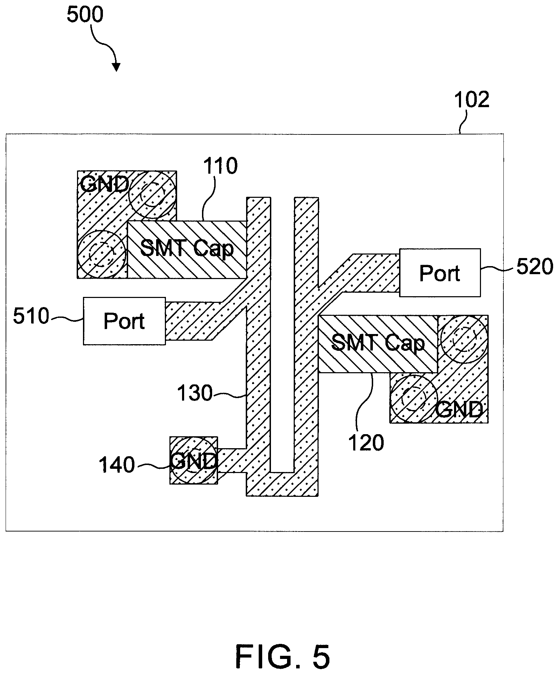

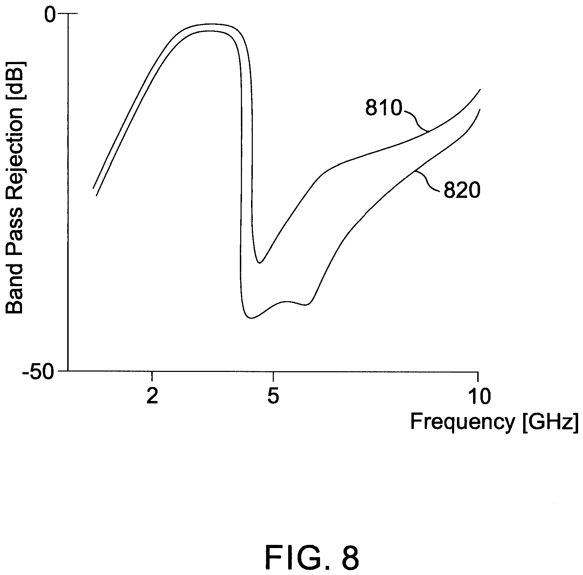

For example, the second node may be located approximately at the same distance to the reference voltage node as the first node (example shown in Fig. 3). For example, a distance between the first node and the reference voltage node 142 may differ from a distance between the second node and the reference voltage node 142 by less than 10% (or less than 5% or less than 2%) of a distance between the first terminal of the first surface-mount technology capacitor 110 and the first terminal of the second surface-mount technology capacitor 120 along the conductive board trace 130. Alternatively, the second node may be disposed closer to the reference voltage node than the first node (example shown in Fig. 5). For example, a distance between the first node and the reference voltage node 142 may differ from a distance between the second node and the reference voltage node 142 by more than 10% (or less than 15% or less than 20%) of a distance between the first terminal of the first surface-mount technology capacitor 110 and the first terminal of the second surface-mount technology capacitor 120 along the conductive board trace 130. By implementing the terminals of the band pass filter 100 with an asymmetric distance to the reference voltage node 142, the insulation of the band pass filter 100 may be improved (example shown in Fig. 8).

For example, a first part of the conductive board trace 130 may form a first inductor of the band pass filter 100 and a second part of the conductive board trace 130 may form a second inductor of the band pass filter 100. The first part of the conductive board trace 130 may be disposed between the first terminal of the first surface-mount technology capacitor 110 and the reference voltage node 142. The second part of the conductive board trace 130 may be disposed between the first terminal of the second surface-mount technology capacitor 120 and the reference voltage node 142. The first inductor and/or the second inductor may be lumped inductors.

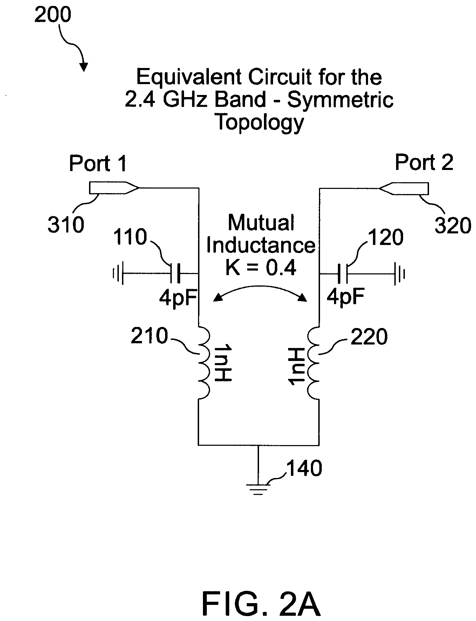

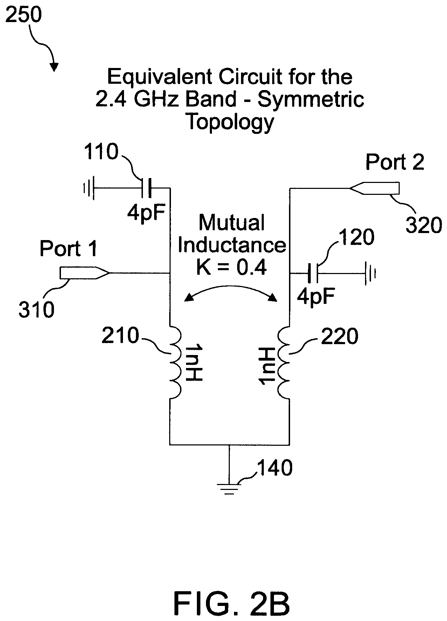

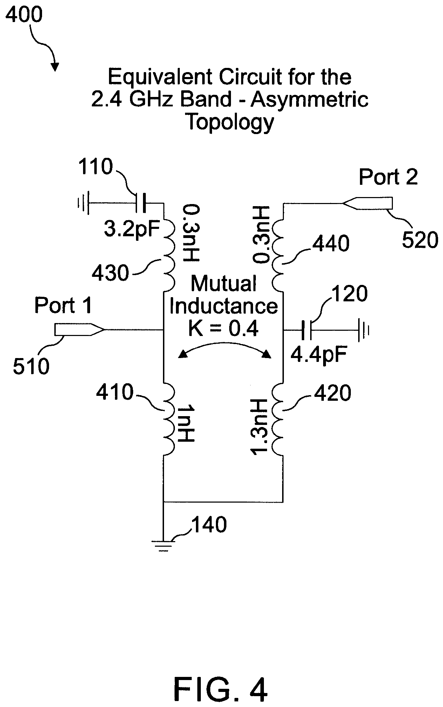

For example, in a symmetric implementation (e.g. as shown in Fig. 2a, 2b or 3), an inductance of the first inductor 210 may be substantially equal (e.g. differs by less than 5%) to an inductance of the second inductor 220. In an asymmetric implementation (e.g. as shown in Fig. 4 or 5), an inductance of the first inductor may differ from an inductance of the second inductor by at least 5% (or at least 10% or at least 20%) of the inductance of the first inductor and/or the inductance of the first inductor may differ from the inductance of the second inductor by at most 50% (or at most 30% or at most 20%) of the inductance of the first inductor.

The inductance of the first inductor may be at least 0.7nH (or at least 0.8nH or at least 0.9nH) and/or at most 1.5nH (or at most 1.3nH or at most 1.2nH). The inductance of the second inductor may be at least 0.7nH (or at least 0.8nH or at least 0.9nH) and/or at most 1.5nH (or at most 1.3nH or at most 1.2nH).

The capacitance of the first surface-mount technology capacitor 110 may be at least 0.2pF (or at least 0.3pF or at least 0.4pF) and/or at most 8pF (or at most 6pF or at most 5pF). The capacitance of the second surface-mount technology capacitor 120 may be at least 0.2pF (or at least 0.3pF or at least 0.4pF) and/or at most 8pF (or at most 6pF or at most 5pF).

For example, at least the first surface-mount technology capacitor 110, the second surface-mount technology capacitor 120, the first inductor 210 and the second inductor 220 may form a resonator with a resonance frequency located within a pass band of the band pass filter. For example, the first inductor 210 may be inductively coupled to the second inductor 220 due to an arrangement in proximity to each other.

For example, the conductive board trace 130 may comprise a shape so that the first part of the conductive board trace 130 implementing the first inductor 210 is located close to the second part of the conductive board trace 130 implementing the second inductor 220 in order to enable a sufficient inductive coupling between the first inductor 210 and the second inductor 220. For example, the first inductor 210 and the second inductor 220 are implemented so that the coupling coefficient k between the first inductor 210 and the second inductor 220 is at least 0.2 (or at least 0.3 or at least 0.4). For example, the conductive board trace 130 may comprise a U-shape. For example, the first terminal of the first surface-mount technology capacitor 110 is connected to a first leg of the U-shaped conductive board trace and the second surface-mount technology capacitor 120 is connected to a second leg of the U-shaped conductive board trace. The legs of the U-shaped conductive board trace may have a distance to each other of less than 1mm (or less than 500µm or less than 300µm). Due to the U-shape, a high magnetic coupling between the legs of the U-shaped conductive board trace may be achievable. In this way, a resonator structure may be obtained, which may enable a high quality band pass filter.

The circuit board 102 may be any board suitable for carrying and connecting electrical devices and/or passive components. For example, the circuit board 102 may be a printed circuit board PCB (e.g. using a glass reinforced epoxy laminate). The circuit board 102 may be a single layer board or multi-layer board. A single layer circuit board may comprise only a single wiring layer for the implementation or routing of signal lines between electrical devices and/or passive components on the circuit board, but may comprise in addition a reference potential layer or plane (e.g. ground plane). For example, a wiring layer may be located at a first side of the circuit board and a reference potential layer or plane may be located at an opposite, second side of the circuit board.

For example, an area of the circuit board occupied by the band pass filter is at most 25 mm² (or at most 16 mm² or at most 9 mm²).

The band pass filter 100 may be a filter for a specific frequency band used for data transmission, for example, according to a wireless communication standard. The band pass filter 100 may be used for any frequency and any bandwidth, with fine tuning of the capacitor values, inductor values and resonators. For example, the band pass filter 100 may be implemented with a pass band adapted to a frequency band used for data transmission. For example, the pass band of the band pass filter 100 may cover the 2.4 GHz band or the 5 GHz band of a wireless local area network WLAN communication or a Bluetooth communication, other Wifi bands (e.g. Dedicated Short Range Communication DSRC 5.9 GHz), a Wigig band (e.g. according to 802.11ad or 802.11ay), and/or a band of a cellular communication system (e.g. LTE or 5G band). Further, a large variety of channel width may be addressed (e.g. 20/40/80/160 MHz ... 8.64 GHz).

For example, the band pass filter 100 may be configured so that an insertion loss of the band pass filter at 2.4 GHz differs from an insertion loss of the band pass filter at 5 GHz by more than 20dB.

For example, the band pass filter 100 may be configured so that an isolation between a first frequency and a second frequency at 180° phase shift is higher than 45dB. For example, the second frequency is twice the first frequency. The first frequency may be 2.4 GHz or 5 GHz.

Fig. 2a shows an equivalent circuit of a 2.4 GHz band pass filter 200 according to an example. The implementation of the band pass filter 200 may be similar to the implementation of the band pass filter described in connection with Fig. 1. A conductive board trace extends from a first terminal of the first surface-mount technology capacitor 110 to a first terminal of the second surface-mount technology capacitor 120. The reference voltage terminal 140 is connected to the conductive board trace at a reference voltage node located between the first surface-mount technology capacitor 110 and the second surface-mount technology capacitor 120. A capacitance of the first surface-mount technology capacitor 110 may be at least 3.5pF and at most 4.5pF (e.g. 4pF) and a capacitance of the second surface-mount technology capacitor 120 may be at least 3.5pF and at most 4.5pF (e.g. 4pF). For example, the capacitance of the first surface-mount technology capacitor 110 is equal to the capacitance of the second surface-mount technology capacitor 120.

A first part of the conductive board trace forms a first inductor 210 of the band pass filter 200 and a second part of the conductive board trace forms a second inductor 220 of the band pass filter 200. An inductance of the first inductor 210 may be at least 0.8 nH and at most 1.2 nH (e.g. 1nH) and an inductance of the second inductor 220 may be at least 0.8 nH and at most 1.2 nH (e.g. 1nH). For example, the inductance of the first inductor 210 is equal to the inductance of the second inductor 220. For example, a mutual inductance k between the first inductor 210 and the second inductor 220 is at least 0.2 (e.g. 0.4). For example, the first inductor 210 and the second inductor 220 are lumped inductors.

A first port 310 is connected to the conductive board trace further away from the reference voltage node than the first surface-mount technology capacitor 110 and a second port 320 is connected to the conductive board trace further away from the reference voltage node than the second surface-mount technology capacitor 120.

For example, the conductive board trace is U-shaped and the first surface-mount technology capacitor 110, the second surface-mount technology capacitor 120, the first inductor 210 and the second inductor 220 form a resonator with a resonance frequency located within a pass band of the band pass filter. For example, the resonance frequency of the resonator may be larger than 2.3 GHz and lower than 2.5 GHz.

More details and aspects are mentioned in connection with the examples described above or below. The example shown in Fig. 2a may comprise one or more optional additional features corresponding to one or more aspects mentioned in connection with the proposed concept or one or more examples described above (e.g. Fig. 1) and below (e.g. Fig. 2b-14).

Fig. 2b shows an equivalent circuit of a 2.4 GHz band pass filter with substantially symmetric topology according to an example. The implementation of the band pass filter 250 may be similar to the implementation of the band pass filter described in connection with Fig. 2a. However, the first port 310 is connected to the conductive board trace between the first surface-mount technology capacitor 110 and the first inductor 210.

More details and aspects are mentioned in connection with the examples described above or below. The example shown in Fig. 2b may comprise one or more optional additional features corresponding to one or more aspects mentioned in connection with the proposed concept or one or more examples described above (e.g. Fig. 1-2a) and below (e.g. Fig. 3-14).

Fig. 3 shows an example of a 2.4GHz Band Pass filter 300 according to an example. The implementation of the band pass filter 300 may be similar to the implementation of the band pass filter described in connection with Fig. 2a. The conductive board trace and the contact interfaces (e.g. solder pads) for the surface-mount technology SMT capacitors 110, 120 are implemented in a single wiring layer at a first side of the circuit board 102. The reference potential node and the second terminals of the surface-mount technology SMT capacitors 110, 120 are connected by ground GND vias to a ground plane located at the second side of the circuit board 102. The ground plane is connected to a reference potential terminal of the circuit board 102.

The conductive board trace 130 comprises a U-shape. The first terminal of the first surface-mount technology capacitor 110 is connected to a first leg of the U-shaped conductive board trace and the second surface-mount technology capacitor 120 is connected to a second leg of the U-shaped conductive board trace. The legs of the U-shaped conductive board trace may have a distance to each other of less than 1mm (or less than 500µm or less than 300µm). Due to the U-shape, a high magnetic coupling between the legs of the U-shaped conductive board trace may be achievable. In this way, a resonator structure may be obtained, which may enable a high quality band pass filter.

More details and aspects are mentioned in connection with the examples described above or below. The example shown in Fig. 3 may comprise one or more optional additional features corresponding to one or more aspects mentioned in connection with the proposed concept or one or more examples described above (e.g. Fig. 1-2) and below (e.g. Fig. 4-14).

Fig. 4 shows an equivalent circuit of a 2.4 GHz band pass filter 400 according to an example. The implementation of the band pass filter 400 may be similar to the implementation of the band pass filter described in connection with Fig. 1 or 2. A conductive board trace extends from a first terminal of the first surface-mount technology capacitor 110 to a first terminal of the second surface-mount technology capacitor 120. The reference voltage terminal 140 is connected to the conductive board trace at a reference voltage node located between the first surface-mount technology capacitor 110 and the second surface-mount technology capacitor 120. A capacitance of the first surface-mount technology capacitor 110 may be at least 3pF and at most 3.5pF (e.g. 3.2pF) and a capacitance of the second surface-mount technology capacitor 120 may be at least 4pF and at most 4.8pF (e.g. 4.4pF). For example, the capacitance of the first surface-mount technology capacitor 110 differs from the capacitance of the second surface-mount technology capacitor 120 by at least 10% of the capacitance of the first surface-mount technology capacitor 110.

A first part of the conductive board trace forms a first inductor 210 of the band pass filter 200 and a second part of the conductive board trace forms a second inductor 220 of the band pass filter 200. An inductance of the first inductor 210 may be at least 0.8 nH and at most 1.2 nH (e.g. 1nH) and an inductance of the second inductor 220 may be at least 1 nH and at most 1.6 nH (e.g. 1.3nH). For example, the inductance of the first inductor 210 differs from the inductance of the second inductor 220 by at least 10% of the inductance of the first inductor 210. For example, a mutual inductance k between the first inductor 210 and the second inductor 220 is at least 0.2 (e.g. 0.4).

A first port 510 is connected to the conductive board trace between the first surface-mount technology capacitor 110 and the first inductor 210 and a second port 520 is connected to the conductive board trace further away from the reference voltage node than the second surface-mount technology capacitor 120. A third part of the conductive board trace implements a third inductor 430 located between the first surface-mount technology capacitor 110 and the node connected to the first port 510. A fourth part of the conductive board trace implements a fourth inductor 440 located between the second surface-mount technology capacitor 120 and the node connected to the second port 520. An inductance of the third inductor 430 may be at least 0.2 nH and at most 0.4 nH (e.g. 0.3nH) and an inductance of the fourth inductor 440 may be at least 0.2 nH and at most 0.4 nH (e.g. 0.3nH).

For example, the first inductor 210, the second inductor 220, the third inductor 430 and the fourth inductor 440 are lumped inductors.

In the example shown in Fig. 4 there may be two sources of asymmetry: the differences in inductance of the "main" inductors (1 nH vs. 1.3 nH) and the extra inductance of the trace between port and SMT capacitor which may be only relevant for the right hand port (extra 0.3 nH). In total there may be 1nH vs. 1.3 nH +0.3nH = 1.6 nH. Alternatively, the same main inductors of 1.0 nH may be used, but instead longer traces between Port and SMT capacitor of 0.6 nH giving the same total result: 1nH vs 1nH +0.6nh =1.6 nH, for example. Alternatively, more different main inductors of 1.0 nH vs. 1.6nH may be used, but instead a symmetric configuration giving the same total result: 1nH vs 1.6nH +0nH =1.6nH, for example.

More details and aspects are mentioned in connection with the examples described above or below. The example shown in Fig. 4 may comprise one or more optional additional features corresponding to one or more aspects mentioned in connection with the proposed concept or one or more examples described above (e.g. Fig. 1-3) and below (e.g. Fig. 5-14).

Fig. 5 shows an example of a 2.4GHz Band Pass filter 500 according to an example. The implementation of the band pass filter 500 may be similar to the implementation of the band pass filter described in connection with Fig. 4. The conductive board trace and the contact interfaces (e.g. solder pads) for the surface-mount technology SMT capacitors 110, 120 are implemented in a single wiring layer at a first side of the circuit board 102. The reference potential node and the second terminals of the surface-mount technology SMT capacitors 110, 120 are connected by ground GND vias to a ground plane located at the second side of the circuit board. The ground plane is connected to a reference potential terminal of the circuit board 102.

The conductive board trace 130 comprises a U-shape. The first terminal of the first surface-mount technology capacitor 110 is connected to a first leg of the U-shaped conductive board trace and the second surface-mount technology capacitor 120 is connected to a second leg of the U-shaped conductive board trace. The legs of the U-shaped conductive board trace may have a distance to each other of less than 1mm (or less than 500µm or less than 300µm). Due to the U-shape, a high magnetic coupling between the legs of the U-shaped conductive board trace may be achievable. In this way, a resonator structure may be obtained, which may enable a high quality band pass filter.

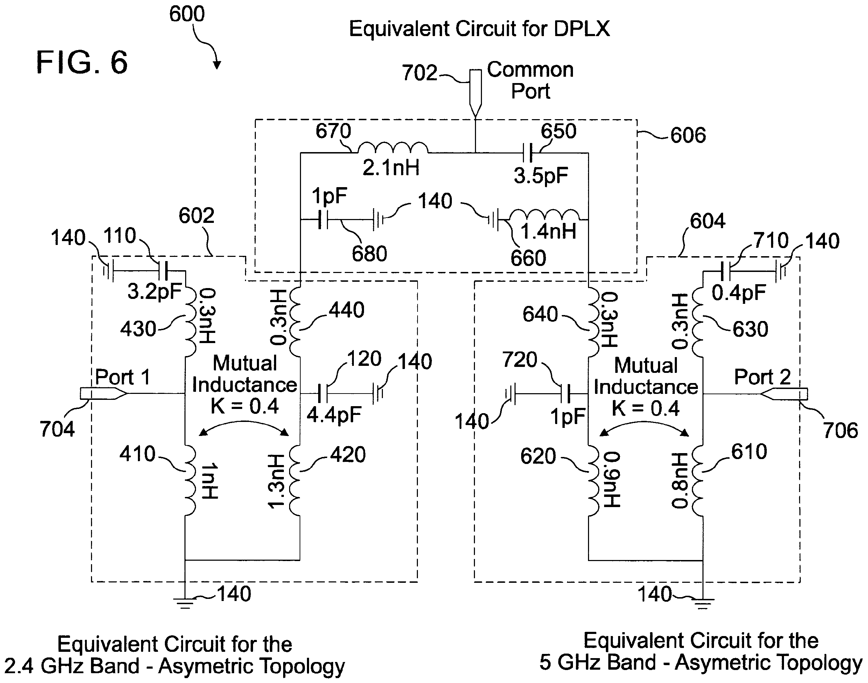

More details and aspects are mentioned in connection with the examples described above or below. The example shown in Fig. 5 may comprise one or more optional additional features corresponding to one or more aspects mentioned in connection with the proposed concept or one or more examples described above (e.g. Fig. 1-4) and below (e.g. Fig. 6-14).

Fig. 6 shows an equivalent circuit of a diplexer 600. The diplexer DPLX 600 comprises a first band pass filter 602 and a second band pass filter 604. The first band pass filter 602 and the second band pass filter 604 may be implemented similar to the band pass filter shown in Fig. 2a, 2b or 4, but the first band pass filter 602 and/or the second band pass filter 604 are adapted so that a pass band of the first band pass filter 602 differs from a pass band of the second band pass filter 604. The first band pass filter 602 may cover a low band and the second band pass filter 604 may cover a high band. For example, the band may be at least 1.5 times the low band and/or at most 10 times the low band.

For example, the first band pass filter 602 comprising the first surface-mount technology capacitor 110 and the second surface-mount technology capacitor 120 is implemented as described in connection with Fig. 4. The second port or terminal of the first band pass filter 602 is connected to an LC matching network 606 of the diplexer 600.

The second band pass filter 604 comprises conductive board trace extending from a first terminal of the first surface-mount technology capacitor 710 of the second band pass filter 604 to a first terminal of the second surface-mount technology capacitor 720 of the second band pass filter 604. The reference voltage terminal 140 is connected to the conductive board trace of the second band pass filter 604 at a reference voltage node located between the first surface-mount technology capacitor 710 of the second band pass filter 604 and the second surface-mount technology capacitor 720 of the second band pass filter 604. A capacitance of the first surface-mount technology capacitor 710 of the second band pass filter 604 may be at least 0.2pF and at most 0.5pF (e.g. 0.4pF) and a capacitance of the second surface-mount technology capacitor 720 of the second band pass filter 604 may be at least 0.8pF and at most 1.2pF (e.g. 1pF). For example, the capacitance of the first surface-mount technology capacitor 710 of the second band pass filter 604 differs from the capacitance of the second surface-mount technology capacitor 720 of the second band pass filter 604 by at least 20% of the capacitance of the first surface-mount technology capacitor 710 of the second band pass filter 604.

A first part of the conductive board trace of the second band pass filter 604 forms a first inductor 610 of the second band pass filter 604 and a second part of the conductive board trace of the second band pass filter 604 forms a second inductor 620 of the second band pass filter 604. An inductance of the first inductor 610 of the second band pass filter 604 may be at least 0.6 nH and at most 1 nH (e.g. 0.8nH) and an inductance of the second inductor 620 of the second band pass filter 604 may be at least 0.7 nH and at most 1.1 nH (e.g. 0.9nH). For example, the inductance of the first inductor 610 of the second band pass filter 604 differs from the inductance of the second inductor 620 of the second band pass filter 604 by at least 10% of the inductance of the first inductor 610 of the second band pass filter 604. For example, a mutual inductance k between the first inductor 610 of the second band pass filter 604 and the second inductor 620 of the second band pass filter 604 is at least 0.2 (e.g. 0.4).

A first port of the second band pass filter 604 is connected to the conductive board trace of the second band pass filter 604 between the first surface-mount technology capacitor 710 of the second band pass filter 604 and the first inductor 610 of the second band pass filter 604 and a second port of the second band pass filter 604 is connected to the conductive board trace of the second band pass filter 604 further away from the reference voltage node than the second surface-mount technology capacitor 720 of the second band pass filter 604. A third part of the conductive board trace of the second band pass filter 604 implements a third inductor 630 of the second band pass filter 604 located between the first surface-mount technology capacitor 710 of the second band pass filter 604 and the node connected to the first port 510 of the second band pass filter 604. A fourth part of the conductive board trace of the second band pass filter 604 implements a fourth inductor 640 located between the second surface-mount technology capacitor 720 of the second band pass filter 604 and the second port 520 of the second band pass filter 604. An inductance of the third inductor 630 of the second band pass filter 604 may be at least 0.2 nH and at most 0.4 nH (e.g. 0.3nH) and an inductance of the fourth inductor 640 of the second band pass filter 604 may be at least 0.2 nH and at most 0.4 nH (e.g. 0.3nH).

The second port or terminal of the second band pass filter 604 is connected to the LC matching network 606 of the diplexer 600.

A first terminal of the LC matching network 606 is connected to the second terminal of the first band pass filter 602 and a second terminal of the LC matching network 606 is connected to the second terminal of the second band pass filter 604. A third terminal of the LC matching network 606 forms a common port 702 of the diplexer 600. A first conductive board trace of the LC matching network 606 extends from the first terminal of the LC matching network 606 to the third terminal of the LC matching network 606 and a second conductive board trace of the LC matching network 606 extends from the second terminal of the LC matching network 606 to a first terminal of a first surface-mount technology capacitor 650 of the LC matching network 606. A second terminal of the first surface-mount technology capacitor 650 of the LC matching network 606 is connected to the third terminal of the LC matching network 606. A first inductor 660 of the LC matching network 606 is connected between the second conductive board trace of the LC matching network 606 and the reference potential terminal 140. A part of the first conductive board trace of the LC matching network 606 implements a second inductor 670 of the LC matching network 606.

A first terminal of a second surface-mount technology capacitor 680 of the LC matching network 606 is connected to the first conductive board trace of the LC matching network 606 between the first terminal of the LC matching network 606 and the second inductor 670 of the LC matching network 606 and a second terminal of the second surface-mount technology capacitor 680 of the LC matching network 606 is connected to the reference potential terminal 140. An inductance of the first inductor 660 of the LC matching network 606 may be at least 1.2 nH and at most 1.6 nH (e.g. 1.4nH) and an inductance of the second inductor 670 of the LC matching network 606 may be at least 1.9 nH and at most 2.3 nH (e.g. 2.1nH). A capacitance of the first surface-mount technology capacitor 650 of the LC matching network 606 may be at least 3.7pF and at most 4.1pF (e.g. 3.9pF) and a capacitance of the second surface-mount technology capacitor 680 of the LC matching network 606 may be at least 0.8pF and at most 1.2pF (e.g. 1pF).

The first port 704 of the diplexer 600 corresponds to the first port of the first band pass filter 602 and may be connected to a first transmitter, receiver or transceiver (e.g. for transmissions in the 2.4 GHz band). The second port 706 of the diplexer 600 corresponds to the first port of the second band pass filter 604 and may be connected to a second transmitter, receiver or transceiver (e.g. for transmissions in the 5 GHz band). The common port 702 may be connected to an antenna (e.g. for transmissions in the 2.4 GHz band and the 5 GHz band).

For example, the first band pass filter may be a 2.4 GHz band pass filter with a pass band covering the 2.4 GHz band of a WLAN communication or Bluetooth communication system and the second band pass filter may be a 5GHz band pass filter with a pass band covering the 5 GHz band of the WLAN communication or Bluetooth communication system.

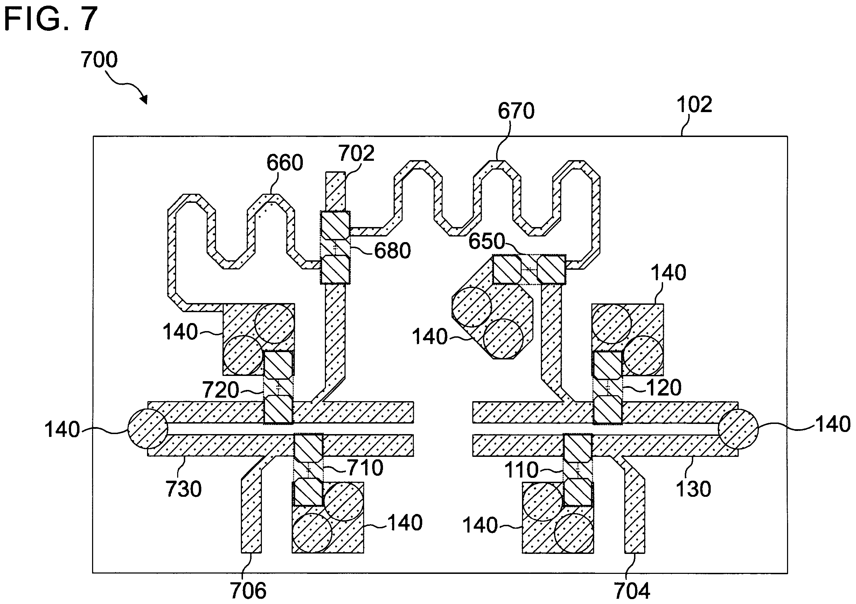

More details and aspects are mentioned in connection with the examples described above or below. The example shown in Fig. 6 may comprise one or more optional additional features corresponding to one or more aspects mentioned in connection with the proposed concept or one or more examples described above (e.g. Fig. 1-5) and below (e.g. Fig. 7-14).

Fig. 7 shows an example of a layout of a diplexer. The implementation of the diplexer 700 may be similar to the implementation of the diplexer described in connection with Fig. 6. The diplexer 700 comprises first band pass filter comprising a first surface-mount technology capacitor 110 attached to a circuit board 102 and a second surface-mount technology capacitor 120 attached to the circuit board 102. Further, the first band pass filter comprises a conductive board trace 130 extending from a first terminal of the first surface-mount technology capacitor 110 to a first terminal of the second surface-mount technology capacitor 120. Additionally, a reference potential terminal 140 is connected to the conductive board trace 130 at a reference potential node located between the first surface-mount technology capacitor 110 and the second surface-mount technology capacitor 120.

Further, the diplexer 700 comprises a second band pass filter comprising a first surface-mount technology capacitor 710 attached to the circuit board 102, a second surface-mount technology capacitor 720 attached to the circuit board 102, and a conductive board trace 730 electrically connecting a first terminal of the first surface-mount technology capacitor 710 to a first terminal of the second surface-mount technology capacitor 720. Additionally, the reference voltage terminal 140 is electrically connected to the conductive board trace 730 of the second band pass filter at a reference voltage node located between the first surface-mount technology capacitor 710 of the second band pass filter and the second surface-mount technology capacitor 720 of the second band pass filter.

Further, the diplexer may comprise an LC matching network. A first terminal of the LC matching network is connected to the second terminal of the first band pass filter and a second terminal of the LC matching network is connected to the second terminal of the second band pass filter. A third terminal of the LC matching network forms a common port 702 of the diplexer 700. A first conductive board trace of the LC matching network extends from the first terminal of the LC matching network to the third terminal of the LC matching network and a second conductive board trace of the LC matching network extends from the second terminal of the LC matching network to a first terminal of a first surface-mount technology capacitor 650 of the LC matching network. A second terminal of the first surface-mount technology capacitor 650 of the LC matching network is connected to the third terminal of the LC matching network. A first inductor 660 of the LC matching network is connected between the second conductive board trace of the LC matching network and the reference potential terminal 140. A part of the first conductive board trace of the LC matching network implements a second inductor 670 of the LC matching network. A first terminal of a second surface-mount technology capacitor 680 of the LC matching network is connected to the first conductive board trace of the LC matching network between the first terminal of the LC matching network and the second inductor 670 of the LC matching network and a second terminal of the second surface-mount technology capacitor 680 of the LC matching network is connected to the reference potential terminal 140.

The first inductor 660 and the second inductor 670 of the LC matching network are implemented by meander-shaped conductive board traces. The first and second inductor of the first band pass filter, the first and second inductor of the second band pass filter and the first and second inductor 660, 670 of the LC matching network may be implemented in the same wiring layer of the circuit board 102.

More details and aspects are mentioned in connection with the examples described above or below. The example shown in Fig. 7 may comprise one or more optional additional features corresponding to one or more aspects mentioned in connection with the proposed concept or one or more examples described above (e.g. Fig. 1-6) and below (e.g. Fig. 8-14).

Fig. 8 shows a schematic illustration of a 2.4GHz band-pass filter response 810 with SMT capacitor located in the locations shown in Fig. 3 vs. a 2.4GHz band-pass filter response 820 with SMT capacitor located in the locations shown in Fig. 5.

The asymmetric layout of Fig. 5 shows an improved isolation between a first mode at 2.4 GHz and a second mode at 4.8 GHz and at 180° phase shift. The performance of the asymmetric layout of Fig. 5 might not be reached by a band-pass filter as shown in Fig. 2a, 2b or 3.

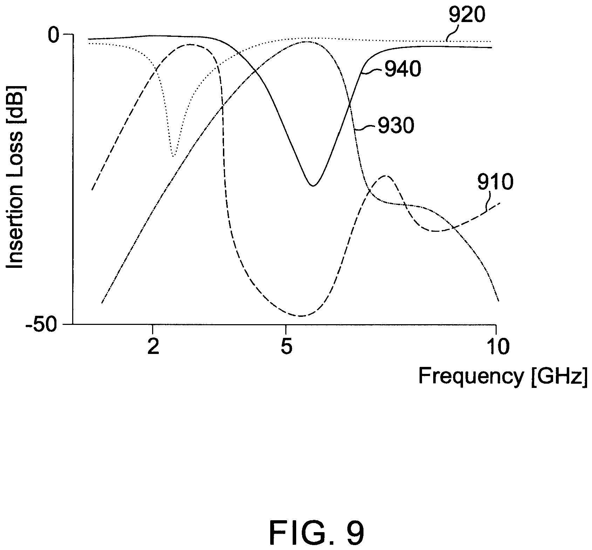

Fig. 9 shows a schematic illustration of a simulated performance of a diplexer as seen from 2.4GHz and 5GHz ports towards the antenna port. The simulated performance may be a performance of the diplexer shown in Fig. 6 and/or 7. Fig. 9 shows the insertion loss 910 of the low band path, the return loss 920 of the low band path, the insertion loss 930 of the high band path and the return loss 940 of the high band path.

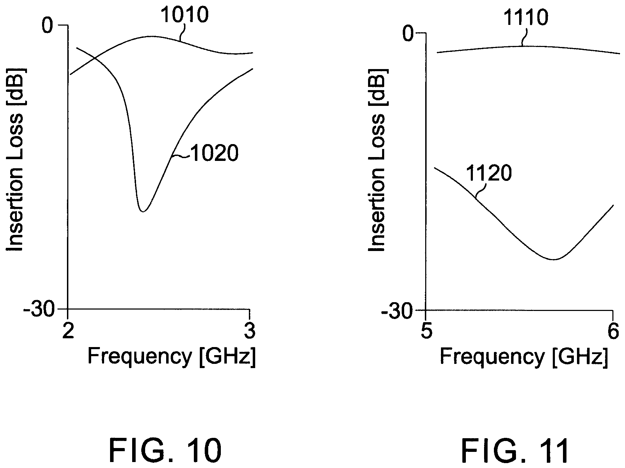

Fig. 10 shows a schematic illustration of a simulated in-band performance of a diplexer as seen from 2.4GHz ports towards the antenna port. The simulated performance may be a performance of the diplexer shown in Fig. 6 and/or 7. Fig. 10 shows the insertion loss 1010 of the low band path and the return loss 1020 of the low band path.

Fig. 11 shows a schematic illustration of a simulated in-band performance of diplexer as seen from 2 5GHz ports towards the antenna port. The simulated performance may be a performance of the diplexer shown in Fig. 6 and/or 7. Fig. 11 shows the insertion loss 1110 of the high band path and the return loss 1120 of the high band path.

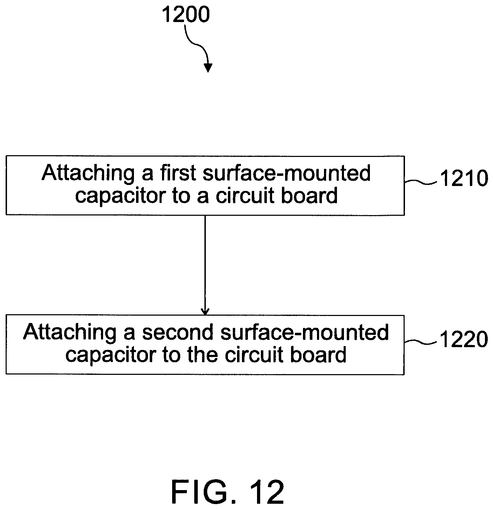

Fig. 12 shows a flow chart of a method for forming a band pass filter according to an example. The method 1200 comprises attaching 1210 a first surface-mount technology capacitor to a circuit board and attaching 1220 a second surface-mount technology capacitor to the circuit board. A conductive board trace electrically connects a first terminal of the first surface-mount technology capacitor to a first terminal of the second surface-mount technology capacitor. Further, a reference voltage terminal is connected to the conductive board trace at a reference voltage node located between the first surface-mount technology capacitor and the second surface-mount technology capacitor.

Due to the usage of SMT capacitors a band pass filter may be manufactured at low costs and/or high reliability and/or low space consumption.

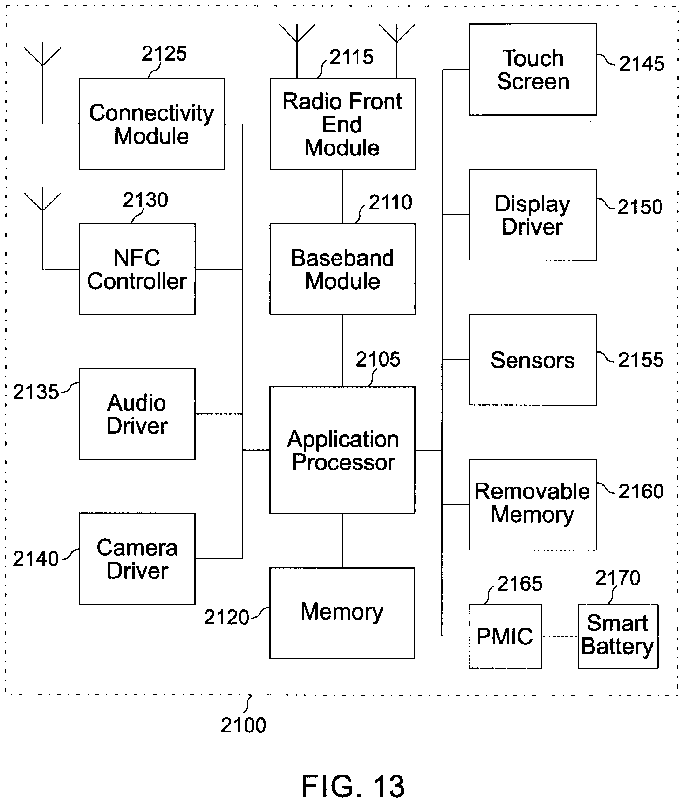

More details and aspects are mentioned in connection with the examples described above or below. The example shown in Fig. 12 may comprise one or more optional additional features corresponding to one or more aspects mentioned in connection with the proposed concept or one or more examples described above (e.g. Fig. 1-11) and below (e.g. Fig. 13-14).

Various examples relate to devices (e.g. cell phone, base station) or components (e.g. transmitter, transceiver) of devices used in wireless or mobile communications systems. A mobile communication system may, for example, correspond to one of the mobile communication systems standardized by the 3rd Generation Partnership Project (3GPP), e.g. Global System for Mobile Communications (GSM), Enhanced Data rates for GSM Evolution (EDGE), GSM EDGE Radio Access Network (GERAN), High Speed Packet Access (HSPA), Universal Terrestrial Radio Access Network (UTRAN) or Evolved UTRAN (E-UTRAN), Long Term Evolution (LTE) or LTE-Advanced (LTE-A), or mobile communication systems with different standards, e.g. Bluetooth, Worldwide Interoperability for Microwave Access (WIMAX) IEEE 802.16 or Wireless Local Area Network (WLAN) IEEE 802.11, generally any system based on Time Division Multiple Access (TDMA), Frequency Division Multiple Access (FDMA), Orthogonal Frequency Division Multiple Access (OFDMA), Code Division Multiple Access (CDMA), etc. The terms mobile communication system and mobile communication network may be used synonymously.

The mobile communication system may comprise a plurality of transmission points or base station transceivers operable to communicate radio signals with a mobile transceiver. In these examples, the mobile communication system may comprise mobile transceivers, relay station transceivers and base station transceivers. The relay station transceivers and base station transceivers can be composed of one or more central units and one or more remote units.

A mobile transceiver or mobile device may correspond to a smartphone, a cell phone, User Equipment (UE), a laptop, a notebook, a personal computer, a Personal Digital Assistant (PDA), a Universal Serial Bus (USB) -stick, a tablet computer, a car, etc. A mobile transceiver or terminal may also be referred to as UE or user in line with the 3GPP terminology. A base station transceiver can be located in the fixed or stationary part of the network or system. A base station transceiver may correspond to a remote radio head, a transmission point, an access point, a macro cell, a small cell, a micro cell, a pico cell, a femto cell, a metro cell etc. The term small cell may refer to any cell smaller than a macro cell, i.e. a micro cell, a pico cell, a femto cell, or a metro cell. Moreover, a femto cell is considered smaller than a pico cell, which is considered smaller than a micro cell. A base station transceiver can be a wireless interface of a wired network, which enables transmission and reception of radio signals to a UE, mobile transceiver or relay transceiver. Such a radio signal may comply with radio signals as, for example, standardized by 3GPP or, generally, in line with one or more of the above listed systems. Thus, a base station transceiver may correspond to a NodeB, an eNodeB, a BTS, an access point, etc. A relay station transceiver may correspond to an intermediate network node in the communication path between a base station transceiver and a mobile station transceiver. A relay station transceiver may forward a signal received from a mobile transceiver to a base station transceiver, signals received from the base station transceiver to the mobile station transceiver, respectively.

The mobile communication system may be cellular. The term cell refers to a coverage area of radio services provided by a transmission point, a remote unit, a remote head, a remote radio head, a base station transceiver, relay transceiver or a NodeB, an eNodeB, respectively. The terms cell and base station transceiver may be used synonymously. In some examples a cell may correspond to a sector. For example, sectors can be achieved using sector antennas, which provide a characteristic for covering an angular section around a base station transceiver or remote unit. In some examples, a base station transceiver or remote unit may, for example, operate three or six cells covering sectors of 120° (in case of three cells), 60° (in case of six cells) respectively. Likewise a relay transceiver may establish one or more cells in its coverage area. A mobile transceiver can be registered or associated with at least one cell, i.e. it can be associated to a cell such that data can be exchanged between the network and the mobile in the coverage area of the associated cell using a dedicated channel, link or connection. A mobile transceiver may hence register or be associated with a relay station or base station transceiver directly or indirectly, where an indirect registration or association may be through one or more relay transceivers.

Figure 13 illustrates a user device 2100 in accordance with an aspect. The user device 2100 may be a mobile device in some aspects and includes an application processor 2105, baseband processor 2110 (also referred to as a baseband module), radio front end module (RFEM) 2115, memory 2120, connectivity module 2125, near field communication (NFC) controller 2130, audio driver 2135, camera driver 2140, touch screen 2145, display driver 2150, sensors 2155, removable memory 2160, power management integrated circuit (PMIC) 2165 and smart battery 2170.

In some aspects, application processor 2105 may include, for example, one or more CPU cores and one or more of cache memory, low drop-out voltage regulators (LDOs), interrupt controllers, serial interfaces such as serial peripheral interface (SPI), inter-integrated circuit (I2C) or universal programmable serial interface module, real time clock (RTC), timer-counters including interval and watchdog timers, general purpose input-output (IO), memory card controllers such as secure digital / multi-media card (SD/MMC) or similar, universal serial bus (USB) interfaces, mobile industry processor interface (MIPI) interfaces and Joint Test Access Group (JTAG) test access ports.

In some aspects, baseband module 2110 may be implemented, for example, as a solder-down substrate including one or more integrated circuits, a single packaged integrated circuit soldered to a main circuit board, and/or a multi-chip module containing two or more integrated circuits.

The radio front end module (RFEM) 2115 or a connectivity module 2125 of the user device 2100 may comprise a band pass filter or a diplexer as described in connection with one or more of the Figs. 1-7.

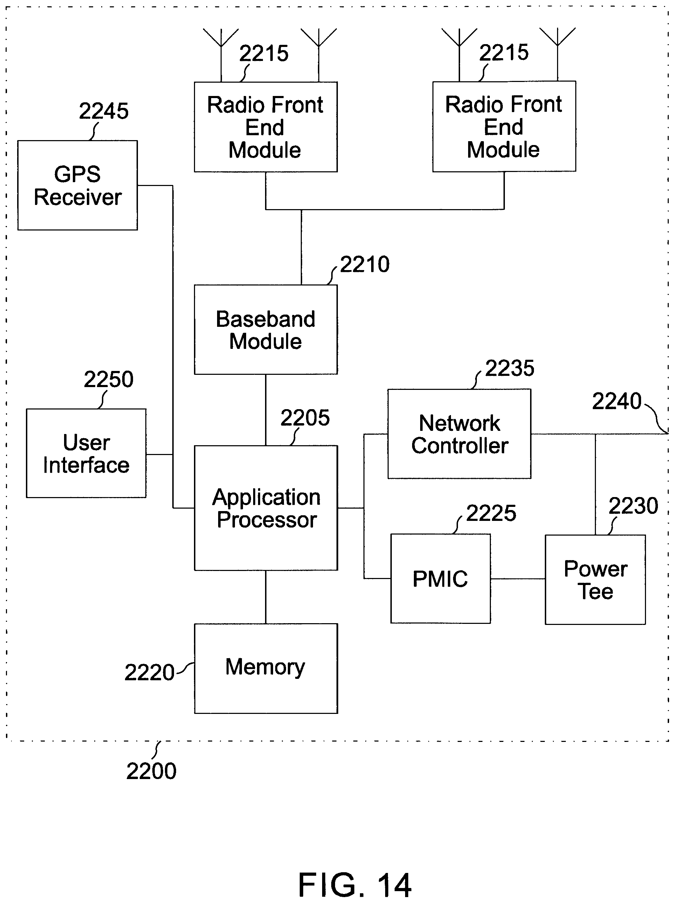

Figure 14 illustrates a base station or infrastructure equipment radio head 2200 in accordance with an aspect. The base station radio head 2200 may include one or more of application processor 2205, baseband modules 2210, one or more radio front end modules 2215, memory 2220, power management circuitry 2225, power tee circuitry 2230, network controller 2235, network interface connector 2240, satellite navigation receiver module 2245, and user interface 2250.

In some aspects, application processor 2205 may include one or more CPU cores and one or more of cache memory, low drop-out voltage regulators (LDOs), interrupt controllers, serial interfaces such as SPI, I2C or universal programmable serial interface module, real time clock (RTC), timer-counters including interval and watchdog timers, general purpose IO, memory card controllers such as SD/MMC or similar, USB interfaces, MIPI interfaces and Joint Test Access Group (JTAG) test access ports.

In some aspects, baseband processor 2210 may be implemented, for example, as a solder-down substrate including one or more integrated circuits, a single packaged integrated circuit soldered to a main circuit board or a multi-chip module containing two or more integrated circuits.

In some aspects, memory 2220 may include one or more of volatile memory including dynamic random access memory (DRAM) and/or synchronous dynamic random access memory (SDRAM), and nonvolatile memory (NVM) including high-speed electrically erasable memory (commonly referred to as Flash memory), phase change random access memory (PRAM), magnetoresistive random access memory (MRAM) and/or a three-dimensional crosspoint memory. Memory 2220 may be implemented as one or more of solder down packaged integrated circuits, socketed memory modules and plug-in memory cards.

In some aspects, power management integrated circuitry 2225 may include one or more of voltage regulators, surge protectors, power alarm detection circuitry and one or more backup power sources such as a battery or capacitor. Power alarm detection circuitry may detect one or more of brown out (under-voltage) and surge (over-voltage) conditions.

In some aspects, power tee circuitry 2230 may provide for electrical power drawn from a network cable to provide both power supply and data connectivity to the base station radio head 2200 using a single cable.

In some aspects, network controller 2235 may provide connectivity to a network using a standard network interface protocol such as Ethernet. Network connectivity may be provided using a physical connection which is one of electrical (commonly referred to as copper interconnect), optical or wireless.

In some aspects, satellite navigation receiver module 2245 may include circuitry to receive and decode signals transmitted by one or more navigation satellite constellations such as the global positioning system (GPS), Globalnaya Navigatsionnaya Sputnikovaya Sistema (GLONASS), Galileo and/or BeiDou. The receiver 2245 may provide data to application processor 2205 which may include one or more of position data or time data. Application processor 2205 may use time data to synchronize operations with other radio base stations. In some aspects, user interface 2250 may include one or more of physical or virtual buttons, such as a reset button, one or more indicators such as light emitting diodes (LEDs) and a display screen.

A radio front end module 2215 of the base station or infrastructure equipment radio head 2200 may comprise a band pass filter or a diplexer as described in connection with one or more of the Figs. 1-7.

Some examples relate to a surface resonance hybrid topology for PCB scale embedded radio frequency RF front end.

Connectivity solutions (e.g. WiFi/BT) may require passive FE that will reject out-of-band frequencies while introducing minimum direct path loss in both 2.4GHz and 5-6GHz operating bands.

According to an aspect an implementation for a diplexer and out of band OOB rejection function at very low cost may be proposed, which may eliminate the need for second vendor and it may be implemented using a single layer of the PCB itself thus also reduce the impact of components and PCB tolerances on overall performance, for example.

A suggested concept may implement the capacitors with surface-mount technology SMT components instead of using substrate plates and may re-locate the capacitors relative to the design ports and the lumped inductors. In this way, the front end FE costs may be reduced, lower z-height profile in general and minimized performance impact due to shield proximity may be enabled and/or sensitivity to PCB tolerances (e.g. due to the single layer usage) may be reduced.

A proposed diplexer may meet all out-of-band rejection requirements using a single layer of the product PCB. The basic building block of the band pass filter may use surface resonance concepts together with SMT capacitors. This building block may then be used for implementing band-pass filter for 2.4GHz frequency range and another for the 5GHz frequency range connected together for a complete diplexer function.

Fig. 3 may show an example of a basic band-pass filter block implementation using SMT caps (e.g. instead of plate capacitor) to eliminate the need for a second PCB layer (e.g. acting as ground plate of the capacitor) which may enable eliminating the dependency on PCB substrate tolerances and may allow more flexible frequency tuning of the design. Optionally, one of the SMT caps may be relocated as shown in Fig. 5, which may result in a significantly better out-of-band rejection as shown in Fig. 8.

Using the suggested concepts, both 2.4GHz and 5GHz band-pass filters may be designed, merged together with LC matching, resulting in a fully functional WiFi/BT diplexer using single glass reinforced epoxy laminate top metal and SMT capacitors, for example. Fig. 7 may show an example of a diplexer layout. Fig. 9-11 show a schematic full bandwidth BW and in-band performance of the diplexer as seen from the 2.4GHz and 5GHz ports towards the antenna port, respectively.

Some concepts may use diplexer and filtering functions implemented using Bismaleimide-Triazine BT-laminate or Low Temperature Co-fired Ceramic LTCC technologies, but they may introduce a major cost adder to the overall front end FE cost, may limit the overall product z-height and/or might not allow customized performance optimization of the full silicon and FE solution.

The description and drawings merely illustrate the principles of the disclosure. Furthermore, all examples recited herein are principally intended expressly to be only for illustrative purposes to aid the reader in understanding the principles of the disclosure and the concepts contributed by the inventor(s) to furthering the art. All statements herein reciting principles, aspects, and examples of the disclosure, as well as specific examples thereof, are intended to encompass equivalents thereof.

A functional block denoted as "means for ..." performing a certain function may refer to a circuit that is configured to perform a certain function. Hence, a "means for s.th." may be implemented as a "means configured to or suited for s.th.", such as a device or a circuit configured to or suited for the respective task.

Functions of various elements shown in the figures, including any functional blocks labeled as "means", "means for providing a signal", "means for generating a signal.", etc., may be implemented in the form of dedicated hardware, such as "a signal provider", "a signal processing unit", "a processor", "a controller", etc. as well as hardware capable of executing software in association with appropriate software. When provided by a processor, the functions may be provided by a single dedicated processor, by a single shared processor, or by a plurality of individual processors, some of which or all of which may be shared. However, the term "processor" or "controller" is by far not limited to hardware exclusively capable of executing software, but may include digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included.

A block diagram may, for instance, illustrate a high-level circuit diagram implementing the principles of the disclosure. Similarly, a flow chart, a flow diagram, a state transition diagram, a pseudo code, and the like may represent various processes, operations or steps, which may, for instance, be substantially represented in computer readable medium and so executed by a computer or processor, whether or not such computer or processor is explicitly shown. Methods disclosed in the specification or in the claims may be implemented by a device having means for performing each of the respective acts of these methods.

It is to be understood that the disclosure of multiple acts, processes, operations, steps or functions disclosed in the specification or claims may not be construed as to be within the specific order, unless explicitly or implicitly stated otherwise, for instance for technical reasons. Therefore, the disclosure of multiple acts or functions will not limit these to a particular order unless such acts or functions are not interchangeable for technical reasons. Furthermore, in some examples a single act, function, process, operation or step may include or may be broken into multiple sub-acts, -functions, -processes, -operations or -steps, respectively. Such sub acts may be included and part of the disclosure of this single act unless explicitly excluded.

## Claims

1. A band pass filter (100, 200, 250, 300, 400, 500) comprising:
a circuit board (102; a first discrete capacitor (110) disposed on the circuit board (102);
a second discrete capacitor (120) disposed on the circuit board (102);
a conductive board trace (130) extending from a first terminal of the first discrete capacitor (110) to a first terminal of the second discrete capacitor (120); and
a reference potential terminal (140) coupled to the conductive board trace (130) at a reference potential node (142) disposed between the first discrete capacitor (110) and the second discrete capacitor (110),
wherein a first part of the conductive board trace (130) forms a first inductor of the band pass filter and a second part of the conductive board trace (130) forms a second inductor of the band pass filter, **characterized in that**
the first part of the conductive board trace (130) is disposed between the first terminal of the first discrete capacitor (110) and the reference potential node (142), wherein the second part of the conductive board trace (130) is disposed between the first terminal of the second discrete capacitor (120) and the reference potential node (142),
wherein an inductance of the first inductor differs from an inductance of the second inductor by at least 5% of the inductance of the first inductor.

2. The band pass filter according to claim 1, further comprising a first terminal of the band pass filter coupled to the conductive board trace (130) at a first node, wherein the first node is disposed closer to the first terminal of the first discrete capacitor (110) than the reference potential node (142).

3. The band pass filter according to claim 2, further comprising a second terminal of the band pass filter coupled to the conductive board trace (130) at a second node, wherein the second node is disposed closer to the first terminal of the second discrete capacitor (120) than the reference potential node (142).

4. The band pass filter according to claim 3, wherein the second node is disposed closer to the reference potential node (142) than the first node.

5. The band pass filter according to one of the previous claims, wherein a second terminal of the first discrete capacitor (110) and a second terminal of the second discrete capacitor (120) are electrically coupled to the reference potential terminal.

6. The band pass filter according to claim 1, wherein the first inductor and the second inductor are lumped inductors.

7. The band pass filter according to one of claims 1-6, wherein the inductance of the first inductor differs from the inductance of the second inductor by at most 50% of the inductance of the first inductor.

8. The band pass filter according to one of the claims 1-7, wherein the inductance of the first inductor is at least 0.7nH and at most 1.5nH.

9. The band pass filter according to one of the previous claims, wherein at least the first discrete capacitor (110), the second discrete capacitor (120), the first inductor and the second inductor form a resonator with a resonance frequency located within a pass band of the band pass filter.

10. The band pass filter according to one of the previous claims, wherein the conductive board trace (130) has a U-shape.

11. The band pass filter according to one of the previous claims, wherein the conductive board trace (130) is implemented in a single wiring layer of the circuit board.

12. A diplexer (600, 700) comprising:
A first band pass filter (602) according to one of the previous claims; and
A second band pass filter (604) comprising a first discrete capacitor of the second band pass filter attached to the circuit board, a second discrete capacitor of the second band pass filter attached to the circuit board, and a conductive board trace of the second band pass filter electrically connecting a first terminal of the first discrete capacitor to a first terminal of the second discrete capacitor, wherein the reference potential terminal is electrically connected to the conductive board trace of the second band pass filter at a reference potential node located between the first discrete capacitor of the second band pass filter and the second discrete capacitor of the second band pass filter.

13. A method (1200) for forming a band pass filter, the method comprising:
Attaching (1210) a first discrete capacitor to a circuit board; and
Attaching (1220) a second discrete capacitor to the circuit board,
wherein a conductive board trace electrically connects a first terminal of the first discrete capacitor to a first terminal of the second discrete capacitor,
wherein a reference potential terminal is connected to the conductive board trace at a reference potential node located between the first discrete capacitor and the second discrete capacitor,
wherein a first part of the conductive board trace forms a first inductor of the band pass filter and a second part of the conductive board trace forms a second inductor of the band pass filter, wherein the first part of the conductive board trace is disposed between the first terminal of the first discrete capacitor and the reference potential node, wherein the second part of the conductive board trace is disposed between the first terminal of the second discrete capacitor and the reference potential node,
wherein an inductance of the first inductor differs from an inductance of the second inductor by at least 5% of the inductance of the first inductor.

## Patentansprüche

1. Bandpassfilter (100, 200, 250, 300, 400, 500), das Folgendes umfasst:
eine Leiterplatte (102); einen ersten diskreten Kondensator (110), der auf der Leiterplatte (102) angeordnet ist;
einen zweiten diskreten Kondensator (120), der auf der Leiterplatte (102) angeordnet ist;
eine Leiterbahn (130), die sich von einem ersten Anschluss des ersten diskreten Kondensators (110) zu einem ersten Anschluss des zweiten diskreten Kondensators (120) erstreckt, und
einen Bezugspotentialanschluss (140), der mit der Leiterbahn (130) an einem Bezugspotentialknoten (142) verbunden ist, der zwischen dem ersten diskreten Kondensator (110) und dem zweiten diskreten Kondensator (110) angeordnet ist,
wobei ein erster Teil der Leiterbahn (130) einen ersten Induktor des Bandpassfilters bildet und ein zweiter Teil der Leiterbahn (130) einen zweiten Induktor des Bandpassfilters bildet,
**dadurch gekennzeichnet, dass** der erste Teil der Leiterbahn (130) zwischen dem ersten Anschluss des ersten diskreten Kondensators (110) und dem Bezugspotentialknoten (142) angeordnet ist, wobei der zweite Teil der Leiterbahn (130) zwischen dem ersten Anschluss des zweiten diskreten Kondensators (120) und dem Bezugspotentialknoten (142) angeordnet ist,
wobei sich eine Induktivität des ersten Induktors von einer Induktivität des zweiten Induktors um mindestens 5 % der Induktivität des ersten Induktors unterscheidet.

2. Bandpassfilter nach Anspruch 1, das ferner einen ersten Anschluss des Bandpassfilters umfasst, der an einem ersten Knoten mit der Leiterbahn (130) der Leiterplatte verbunden ist, wobei der erste Knoten näher an dem ersten Anschluss des ersten diskreten Kondensators (110) angeordnet ist als der Bezugspotentialknoten (142).

3. Bandpassfilter nach Anspruch 2, das ferner einen zweiten Anschluss des Bandpassfilters umfasst, der an einem zweiten Knoten mit der Leiterbahn (130) der Leiterplatte verbunden ist, wobei der zweite Knoten näher an dem ersten Anschluss des zweiten diskreten Kondensators (120) angeordnet ist als der Bezugspotentialknoten (142).

4. Bandpassfilter nach Anspruch 3, wobei der zweite Knoten näher an dem Bezugspotentialknoten (142) angeordnet ist als der erste Knoten.

5. Bandpassfilter nach einem der vorhergehenden Ansprüche, wobei ein zweiter Anschluss des ersten diskreten Kondensators (110) und ein zweiter Anschluss des zweiten diskreten Kondensators (120) elektrisch mit dem Bezugspotentialanschluss gekoppelt sind.

6. Bandpassfilter nach Anspruch 1, wobei der erste Induktor und der zweite Induktor konzentrierte Induktoren sind.

7. Bandpassfilter nach einem der Ansprüche 1-6, wobei sich die Induktivität des ersten Induktors von der Induktivität des zweiten Induktors um höchstens 50 % der Induktivität des ersten Induktors unterscheidet.

8. Bandpassfilter nach einem der Ansprüche 1-7, wobei die Induktivität des ersten Induktors mindestens 0,7 nH und höchstens 1,5 nH beträgt.

9. Bandpassfilter nach einem der vorhergehenden Ansprüche, wobei zumindest der erste diskrete Kondensator (110), der zweite diskrete Kondensator (120), der erste Induktor und der zweite Induktor einen Resonator mit einer Resonanzfrequenz bilden, die innerhalb eines Durchlassbereichs des Bandpassfilters liegt.

10. Bandpassfilter nach einem der vorhergehenden Ansprüche, wobei die Leiterbahn (130) eine U-Form hat.

11. Bandpassfilter nach einem der vorhergehenden Ansprüche, wobei die Leiterbahn (130) in einer einzigen Verdrahtungsschicht der Leiterplatte implementiert ist.

12. Diplexer (600, 700), der Folgendes umfasst:
ein erstes Bandpassfilter (602) nach einem der vorhergehenden Ansprüche; und
ein zweites Bandpassfilter (604), das einen ersten diskreten Kondensator des zweiten Bandpassfilters umfasst, der an der Leiterplatte befestigt ist, einen zweiten diskreten Kondensator des zweiten Bandpassfilters, der an der Leiterplatte befestigt ist, und eine Leiterbahn des zweiten Bandpassfilters, die einen ersten Anschluss des ersten diskreten Kondensators mit einem ersten Anschluss des zweiten diskreten Kondensators elektrisch verbindet, wobei der Bezugspotentialanschluss elektrisch mit der Leiterbahn des zweiten Bandpassfilters an einem Bezugspotentialknoten verbunden ist, der zwischen dem ersten diskreten Kondensator des zweiten Bandpassfilters und dem zweiten diskreten Kondensator des zweiten Bandpassfilters liegt.

13. Verfahren (1200) zur Herstellung eines Bandpassfilters, wobei das Verfahren Folgendes umfasst:
Anbringen (1210) eines ersten diskreten Kondensators an einer Leiterplatte, und
Anbringen (1220) eines zweiten diskreten Kondensators an der Leiterplatte,
wobei eine Leiterbahn einen ersten Anschluss des ersten diskreten Kondensators mit einem ersten Anschluss des zweiten diskreten Kondensators elektrisch verbindet,
wobei ein Bezugspotentialanschluss mit der Leiterbahn an einem Bezugspotentialknoten verbunden ist, der sich zwischen dem ersten diskreten Kondensator und dem zweiten diskreten Kondensator befindet,
wobei ein erster Teil der Leiterbahn eine erste Induktivität des Bandpassfilters bildet und ein zweiter Teil der Leiterbahn eine zweite Induktivität des Bandpassfilters bildet, wobei der erste Teil der Leiterbahn zwischen dem ersten Anschluss des ersten diskreten Kondensators und dem Bezugspotentialknoten angeordnet ist, wobei der zweite Teil der Leiterbahn zwischen dem ersten Anschluss des zweiten diskreten Kondensators und dem Bezugspotentialknoten angeordnet ist,
wobei sich eine Induktivität des ersten Induktors von einer Induktivität des zweiten Induktors um mindestens 5 % der Induktivität des ersten Induktors unterscheidet.

## Revendications

1. Filtre passe-bande (100, 200, 250, 300, 400, 500) comprenant :
une carte de circuit imprimé (102) ;
un premier condensateur discret (110) disposé sur la carte de circuit imprimé (102) ;
un second condensateur discret (120) disposé sur la carte de circuit imprimé (102) ;
une piste de carte conductrice (130) s'étendant d'une première borne du premier condensateur discret (110) à une première borne du second condensateur discret (120) ; et
une borne de potentiel de référence (140) couplée à la piste de carte conductrice (130) au niveau d'un noeud de potentiel de référence (142) disposé entre le premier condensateur discret (110) et le second condensateur discret (110),
dans lequel une première partie de la piste de carte conductrice (130) forme un premier inducteur du filtre passe-bande et une seconde partie de la piste de carte conductrice (130) forme un second inducteur du filtre passe-bande, **caractérisé en ce que** la première partie de la piste de carte conductrice (130) est disposée entre la première borne du premier condensateur discret (110) et le noeud de potentiel de référence (142), dans lequel la seconde partie de la piste de carte conductrice (130) est disposée entre la première borne du second condensateur discret (120) et le noeud de potentiel de référence (142),
dans lequel une inductance du premier inducteur diffère d'une inductance du second inducteur par au moins 5% de l'inductance du premier inducteur.

2. Filtre passe-bande selon la revendication 1, comprenant en outre une première borne du filtre passe-bande couplée à la piste de carte conductrice (130) au niveau d'un premier noeud, dans lequel le premier noeud est disposé plus près de la première borne du premier condensateur discret (110) que du noeud de potentiel de référence (142).

3. Filtre passe-bande selon la revendication 2, comprenant en outre une seconde borne du filtre passe-bande couplée à la piste de carte conductrice (130) au niveau d'un second noeud, dans lequel le second noeud est disposé plus près de la première borne du second condensateur discret (120) que du noeud de potentiel de référence (142).

4. Filtre passe-bande selon la revendication 3, dans lequel le second noeud est disposé plus près du noeud de potentiel de référence (142) que le premier noeud.

5. Filtre passe-bande selon l'une des revendications précédentes, dans lequel une seconde borne du premier condensateur discret (110) et une seconde borne du second condensateur discret (120) sont couplées électriquement à la borne de potentiel de référence.

6. Filtre passe-bande selon la revendication l, dans lequel le premier inducteur et le second inducteur sont des inducteurs à éléments localisés.

7. Filtre passe-bande selon l'une des revendications 1 à 6, dans lequel l'inductance du premier inducteur diffère de l'inductance du second inducteur par au plus 500 %de l'inductance du premier inducteur.

8. Filtre passe-bande selon l'une des revendications 1 à 7, dans lequel l'inductance du premier inducteur est au moins 0,7nH et au plus 1,5nH.

9. Filtre passe-bande selon l'une des revendications précédentes, dans lequel au moins le premier condensateur discret (110), le second condensateur discret (120), le premier inducteur et le second inducteur forment un résonateur ayant une fréquence de résonance située dans une bande passante du filtre passe-bande.

10. Filtre passe-bande selon l'une des revendications précédentes, dans lequel la piste de carte conductrice (130) a une forme en U.

11. Filtre passe-bande selon l'une des revendications précédentes, dans lequel la piste de carte conductrice (130) est implémentée dans une seule couche de câblage de la carte de circuit imprimé.

12. Diplexeur (600, 700) comprenant :
un premier filtre passe-bande (602) selon l'une des revendications précédentes ; et
un second filtre passe-bande (604) comprenant un premier condensateur discret du second filtre passe-bande fixé à la carte de circuit imprimé, un second condensateur discret du second filtre passe-bande fixé à la carte de circuit imprimé et une piste de carte conductrice du second filtre passe-bande connectant électriquement une première borne du premier condensateur discret à une première borne du second condensateur discret, dans lequel la borne de potentiel de référence est connectée électriquement à la piste de carte conductrice du second filtre passe-bande au niveau d'un noeud de potentiel de référence situé entre le premier condensateur discret du second filtre passe-bande et le second condensateur discret du second filtre passe-bande.

13. Procédé (1200) de formation d'un filtre passe-bande, le procédé comprenant :
la fixation (1210) d'un premier condensateur discret à une carte de circuit imprimé ; et
la fixation (1220) d'un second condensateur discret à la carte de circuit imprimé,
dans lequel une piste de carte conductrice connecte électriquement une première borne du premier condensateur discret à une première borne du second condensateur discret,
dans lequel une borne de potentiel de référence est connectée à la piste de carte conductrice au niveau d'un noeud de potentiel de référence situé entre le premier condensateur discret et le second condensateur discret,
dans lequel une première partie de la piste de carte conductrice forme un premier inducteur du filtre passe-bande et une seconde partie de la piste de carte conductrice forme un second inducteur du filtre passe-bande, dans lequel la première partie de la piste de carte conductrice est disposée entre la première borne du premier condensateur discret et le noeud de potentiel de référence, dans lequel la seconde partie de la piste de carte conductrice est disposée entre la première borne du second condensateur discret et le noeud de potentiel de référence,
dans lequel une inductance du premier inducteur diffère d'une inductance du second inducteur par au moins 5 % de l'inductance du premier inducteur.
